(19) Europäisches Patentamt
European Patent Office
Office européen des brevets

(11) **EP 1 456 890 B1**

(12) **EUROPÄISCHE PATENTSCHRIFT**

(45) Veröffentlichungstag und Bekanntmachung des Hinweises auf die Patenterteilung:
**29.04.2009 Patentblatt 2009/18**

(21) Anmeldenummer: **02805320.5**

(22) Anmeldetag: **12.12.2002**

(51) Int Cl.:
*H01L 29/866* (2006.01)    *H01L 21/329* (2006.01)

(86) Internationale Anmeldenummer:
**PCT/EP2002/014174**

(87) Internationale Veröffentlichungsnummer:
**WO 2003/054971 (03.07.2003 Gazette 2003/27)**

(54) **ZENERDIODE, ZENERDIODENSCHALTUNG UND VERFAHREN ZUR HERSTELLUNG EINER ZENERDIODE**

ZENER DIODE, ZENER DIODE CIRCUIT AND METHOD FOR PRODUCTION OF A ZENER DIODE

DIODE ZENER, CIRCUIT DE DIODE ZENER ET PROCEDE DE FABRICATION D'UNE DIODE ZENER

(84) Benannte Vertragsstaaten:
**AT BE BG CH CY CZ DE DK EE ES FI FR GB GR IE IT LI LU MC NL PT SE SI SK TR**

(30) Priorität: **21.12.2001 DE 10163484**

(43) Veröffentlichungstag der Anmeldung:
**15.09.2004 Patentblatt 2004/38**

(73) Patentinhaber: **Austriamicrosystems AG 8141 Unterpremstätten (AT)**

(72) Erfinder: **UNTERLEITNER, Franz A-8401 Kalsdorf (AT)**

(74) Vertreter: **Epping - Hermann - Fischer Patentanwaltsgesellschaft mbH Ridlerstraße 55 80339 München (DE)**

(56) Entgegenhaltungen:
**EP-A- 0 054 740        EP-A- 0 612 109
EP-A- 0 883 193        US-A- 4 589 002
US-A- 4 646 114        US-A- 4 672 403
US-A- 5 990 534**

• **PATENT ABSTRACTS OF JAPAN vol. 011, no. 382 (E-564), 12. Dezember 1987 (1987-12-12) & JP 62 145879 A (SANYO ELECTRIC CO LTD;OTHERS: 01), 29. Juni 1987 (1987-06-29)**

**Beschreibung**

Die Erfindung betrifft eine Zenerdiode mit einem halbleitenden Substrat, das ein n-dotiertes und ein p-dotiertes Gebiet aufweist und bei der die dotierten Gebiete einen pn-Übergang bilden. Ferner betrifft die Erfindung eine Schaltung mit der Zenerdiode. Darüber hinaus betrifft die Erfindung ein Verfahren zur Herstellung der Zenerdiode.

Aus der Druckschrift US 5,990,534 sind Zenerdioden der eingangs genannten Art bekannt, bei denen der pn-Übergang ein vertikal in einem halbleitenden Substrat angeordneter Übergang ist. Ein solcher pn-Übergang hat den Nachteil, daß er wegen der benötigten verschiedenen Eindringtiefen mit den üblichen Herstellungsverfahren für integrierte Schaltkreise nicht hergestellt werden kann. Darüber hinaus eignen sich die bekannten Zenerdioden nicht als einmalig programmierbares Bauelement, da der pn-Übergang relativ großflächig ist und somit ein hoher Strom zum Durchbrennen des pn-Übergangs notwendig wäre.

Es sind darüber hinaus aus der Druckschrift US 4,672, 403 Zenerdioden der eingangs genannten Art bekannt, bei denen der pn-Übergang ein lateraler Übergang ist. Das n-Gebiet ist dabei in Form einer Spitze ausgebildet. Durch eine solche Spitze können die durch die Diode fließenden Ströme gut konzentriert werden, weswegen zum Durchbrennen einer solchen Diode ein geringerer Strom notwendig ist. Jedoch hat auch diese bekannte Diode den Nachteil, daß sie wegen der benötigten verschiedenen Eindringtiefen mit den üblichen Herstellungsverfahren für integrierte Schaltkreise nicht hergestellt werden kann.

Zenerdioden mit dotierten Gebieten, denen Breite an Richtung pn -Übergang vemingent ist, sind aus EP-A-54740 and EP-A-883 193 (entspricht der Präambel des Anspruchs 1) bekannt.

Zenerdioden der eingangs genannten Art werden verwendet für einmalige programmierbare Bauelemente. Dabei wird die Zenerdiode durch einen ausreichend hohen Strom durchgebrannt oder auch durchlegiert, wodurch ein ohmscher Widerstand anstelle der Zenerdiode entsteht. Dabei werden die Zenerdioden in Sperrichtung während des Durchbrennens belastet.

Des weiteren haben die bekannten Zenerdioden den Nachteil, daß der Überlapp des p- und des n-dotierten Gebietes relativ groß ist, wodurch die Leckströme der Zenerdioden hoch sind.

Aufgabe der vorliegenden Erfindung ist es daher, eine Zenerdiode anzugeben, die einen relativ geringen Leckstrom aufweist.

Es ist eine weitere Aufgabe der Erfindung, ein Verfahren zur Herstellung einer Zenerdiode anzugeben.

Diese Aufgaben werden durch eine Zenerdiode nach Patentanspruch 1 sowie durch ein Verfahren zur Herstellung einer Zenerdiode nach Patentanspruch 13 und 14 gelöst. Vorteilhafte Ausgestaltungen der Zenerdiode bzw. des Verfahrens zur Herstellung der Zenerdiode sind den weiteren Ansprüchen zu entnehmen.

Es wird eine Zenerdiode angegeben, die ein halbleitendes Substrat aufweist. In dem halbleitenden Substrat befinden sich n- und p-dotierte Gebiete. Zwei der dotierten Gebiete bilden einen lateralen pn-Übergang. Die zueinander zugewandten Seiten der dotierten Gebiete weisen zum jeweils anderen dotierten Gebiet hin eine abnehmende Breite auf.

Eine solche Zenerdiode hat den Vorteil, daß auf Grund der abnehmenden Breite der eigentliche pn-Übergang relativ klein ist, weswegen eine solche Diode nur einen geringen Leckstrom aufweist. Geringe Leckströme sind vorteilhaft, weil einerseits der Gesamtstromverbrauch eines Schaltkreises verringert werden kann, andererseits bei der Anwendung als programmierbares Element der Unterschied zwischen dem programmierten Zustand (niederohmig, hoher Stromfluß) und dem ungebrannten Zustand (hochohmig, nur kleiner Leckstrom) deutlicher ausfällt und daher eine vergrößerte Unterscheidungssicherheit bietet.

Darüber hinaus haben solche Zenerdioden den Vorteil, daß auf Grund der abnehmenden Breite der dotierten Gebiete ein durch die Diode fließender Strom räumlich auf den Übergang zwischen den beiden Gebieten hin konzentriert werden kann, wodurch eine vorteilhafte Lokalisierung der durch den Strom erzeugten Wärmeenergie in dem Bauelement stattfindet. Dadurch kann mit einem relativ geringen Strom ein Durchbrennen der Diode zum Speichern einer Information erreicht werden.

Die einander zugewandten Enden der dotierten Gebiete können eine Mindestbreite aufweisen. Demnach haben die dotierten Gebiete die Umrisse in Form von einander zugewandeten Trapezen. Diese Trapeze gehen hervor aus dreieckförmigen Gebieten, wobei die zueinander gewandten Spitzen der Dreiecke jeweils abgeflacht sind. Durch die Mindestbreiten an den Enden der dotierten Gebiete kann erreicht werden, daß bei Fehljustierung der für die Herstellung der dotierten Gebiete verwendeten Masken im Gegensatz zu spitz ausgeführten Enden der dotierten Gebiete noch eine Überlappung der dotierten Gebiete und mithin ein funktionierender pn-Übergang erreicht werden kann. Mit Hilfe der Mindestbreiten an den Enden der dotierten Gebiete ist es also möglich, eine Fehljustierung bei der Herstellung der dotierten Gebiete auszugleichen.

Die dotierten Gebiete können an ihren Enden beispielsweise durch gerade Kanten begrenzt sein.

Es wird darüber hinaus eine Zenerdiode angegeben, die ein weiteres p-dotiertes Gebiet aufweist. Eine Zenerdiode kann auch ein weiteres n-dotiertes Gebiet aufweisen. Das n-dotierte Gebiet ist zwischen zwei p-dotierten Gebieten angeordnet. Es kann aber auch das p-dotierte Gebiet zwischen zwei n-dotierten Gebieten angeordnet sein. Das n-dotierte Gebiet bildet mit jedem der benachbarten p-dotierten Gebiete einen lateralen pn-Übergang. Genauso kann das p-dotierte Gebiet mit jedem der benachbarten n-dotierten Gebiete einen lateralen pn-Übergang bilden. Bei einer solchen Zenerdiode können die beiden pn-Übergänge parallel zueinander geschaltet werden. Dazu werden die p-dotierten Gebiete mit einem ersten äußeren Anschluß und die n-dotierten Gebiete mit einem zweiten äußeren Anschluß verbunden. Dadurch entsteht eine Doppel-Zenerdiode, die ähnliche Eigenschaften wie eine einfache Zenerdiode aufweist. Insbesondere kann eine solche Doppel-Zenerdiode durch einen Strom programmiert werden.

Die Doppel-Zenerdioden haben den Vorteil, daß Fehljustierungen der für die Herstellung der Dioden verwendeten Masken ausgeglichen werden können. Das zwischen den beiden äußeren dotierten Gebieten liegende dotierte Gebiet kann innerhalb von durch die Justiergenauigkeit vorgegebenen Grenzen zwischen den beiden äußeren Gebieten wandern. Es kann näher bei dem einen oder auch näher bei dem anderen der dotierten Gebiete liegen. Da die anderen geometrischen Größen konstant sind, ist auch die Summe der Abstände zwischen dem mittleren dotierten Gebiet und dem ersten äußeren dotierten Gebiet sowie zwischen dem mittleren dotierten Gebiet und dem anderen äußeren dotierten Gebiet konstant. Ein größerer Abstand auf der einen Seite wird also durch einen kleineren Abstand auf der anderen Seite kompensiert. Dadurch kann innerhalb gewisser durch die Technologie vorgegebener Grenzen eine Kompensation von Fehljustierungen stattfinden.

Bei einer Zenerdiode können auch alle dotierten Gebiete innerhalb einer einzigen Öffnung eine Diffusionsmaske angeordnet sein. Als Diffusionsmaske werden üblicherweise Feldoxydmasken aus $SiO_2$ verwendet. Das Anordnen aller dotierten Gebiete in einer einzigen Öffnung einer Diffusionsmaske hat den Vorteil, daß nicht weitere Fehler bei der Zenerdiode auf Grund von Fehlern bei der Justierung der Diffusionsmaske auftreten können.

Die n- bzw. p-dotierten Gebiete können jeweils für sich symmetrisch zu einer senkrecht zur Substratoberfläche verlaufenden Ebene ausgebildet sein. Durch eine solche Symmetrie wird zum einen die Herstellung der dotierten Gebiete vereinfacht, da einmal hergestellte Strukturen durch Spiegelung aufeinander abgebildet werden können. Des weiteren hat die symmetrische Ausführung der dotierten Gebiete den Vorteil, daß im Falle einer Doppel-Zenerdiode eine noch bessere Kompensation von Fehljustierungen entlang der Verbindungsachse der äußeren dotierten Gebiete möglich ist.

Die dotierten Gebiete können p+ bzw. n+ dotiert sein. Dadurch wird die Zahl der Ladungsträger in den jeweiligen dotierten Gebieten erhöht, was eine verbesserte Leitfähigkeit zur Folge hat.

Zur Bildung eines pn-Übergangs können die p- bzw. n-dotierten Gebiete einander überlappen.

Die Z-Diode bzw. die dotierten Gebiete der Z-Diode können durch photolithographische Masken hergestellt werden. Die Mindestbreite kann an die maximal zu erwartende Fehljustierung der Masken zueinander in Richtung der Breite der dotierten Gebiete angepaßt werden. Dazu ist es vorteilhaft, wenn die Mindestbreite der dotierten Gebiete größer ist als die zu erwartende Fehljustierung in dieser Richtung. So kann gewährleistet werden, daß auch bei maximaler Fehljustierung noch ein Überlapp der beiden dotierten Gebiete stattfindet, wodurch ein funktionierende Diode sichergestellt werden kann.

In ähnlicher Art und Weise kann bei einer Doppel-Zenerdiode der Abstand zwischen den äußeren dotierten Gebieten, also der Abstand derjenigen dotierten Gebiete, die dieselbe Dotierungspolarität aufweisen, an die maximale zu erwartende Fehljustierung in Richtung der Verbindung zwischen den äußeren dotierten Gebieten angepaßt sein. Diese Anpassung wird in Verbindung mit der Ausdehnung des dazwischenliegenden dotierenden Gebietes durchgeführt. Insgesamt muß gewährleistet sein, daß auch bei maximaler Fehljustierung noch wenigstens ein funktionierender pn-Übergang hergestellt wird. Dazu ist der Abstand der äußeren dotierten Gebiete bzw. die Abmessung des inneren dotierten Gebietes so zu wählen, daß die Abmessung des inneren dotierten Gebietes zusammen mit der maximalen Fehljustierung in etwa den Abstand der beiden äußeren dotierten Gebiete von einander ergibt.

Es wird eine Zenerdiodenschaltung angegeben, bei der die Zenerdiode mit einem Mittel zum Einprägen eines elektrischen Stromes verbunden ist und bei der die Zenerdiode mit Mitteln zum Auslesen des Zustandes der Zenerdiode verbunden ist.

Dadurch kann die Zenerdiode mittels eines programmierbaren Stromes programmiert werden. Das heißt, daß die Zenerdiode irreversibel von einem Zustand vor dem Durchbrennen in einen Zustand nach dem Durchbrennen, also in einen Zustand mit ohmschem Widerstand überführt wird. Dieser Zustand kann nun zum Feststellen des Programmierzustandes der Zenerdiode ausgelesen werden.

Es wird darüber hinaus ein Verfahren zur Herstellung einer Zenerdiode angegeben, wobei zwei Masken photolithographisch auf einem Halbleiter-Substrat erzeugt werden. Solche Masken können beispielsweise durch Strukturieren von Photolack erzeugt werden. Das Strukturieren des Photolacks kann beispielsweise optisch mittels Licht erfolgen. Die erste Maske weist eine erste Öffnung auf der Substratoberfläche auf. Die zweite Maske weist eine zweite Öffnung auf der Substratoberfläche auf. Die Öffnungen weisen auf den einander zugewandten Seiten eine abnehmende Breite auf, die bis auf eine endliche Mindestbreite hin abnimmt. Die Mindestbreite ist an die maximal zu erwartende Fehljustierung der Öffnungen zu einander angepaßt. Unterhalb der ersten Öffnung wird das Substrat n-oder p-dotiert. Unterhalb der zweiten Öffnung wird das Substrat mit einer zur ersten Öffnung entgegengesetzten Dotierung dotiert. Beispielsweise wird das zweite das Substrat unterhalb der zweiten Öffnung p-dotiert. Darüber hinaus werden folgende Verfahrensschritte durchgeführt:

    a) Herstellen der ersten Maske

b) Justieren der zweiten Maske relativ zur ersten Maske

c) Herstellen der zweiten Maske.

Das Verfahren hat den Vorteil, daß Fehljustierungen der Masken zueinander durch die geometrische Ausbildung der Öffnungen der Masken entsprechend der Verfahrensweise bei den Zenerdioden ausgeglichen werden können.

Darüber hinaus wird ein Verfahren zur Herstellung einer Zenerdiode angegeben, wobei zwei Masken photolithographisch auf der Oberfläche eines Halbleitersubstrats erzeugt werden, wobei die erste Maske eine erste Öffnung auf der Oberfläche des Halbleitersubstrates aufweist. Die zweite Maske weist zwei weitere Öffnungen auf der Oberfläche des Halbleitersubstrates auf. Die erste Öffnung ist zwischen den beiden weiteren angeordnet. Die Öffnungen weisen auf den einander zugewandten Seiten eine abnehmende Breite auf, die bis auf eine endliche Mindestbreite abnimmt. Die Mindestbreite ist an die maximale zu erwartende Fehljustierung der Masken zueinander in Richtung der Breite angepaßt. Das Halbleitersubstrat unterhalb der ersten Öffnung wird n- oder p-dotiert. Das Halbleitersubstrat unterhalb der beiden anderen Öffnungen wird mit einer entgegengesetzten Dotierung, also p- oder n-Dotierung versehen. Darüber hinaus werden die folgenden Schritte durchgeführt:

a) Herstellen der ersten Maske
b) Justieren der zweiten Maske relativ zur ersten Maske
c) Herstellen der zweiten Maske

Das Verfahren zur Herstellung der Zenerdiode hat den Vorteil, daß auch Fehljustierungen senkrecht zur Breite der Öffnungen durch Kompensation ausgeglichen werden können. Das gelingt insbesondere dann, wenn der Abstand der zweiten Öffnungen voneinander sowie die Länge der ersten Öffnung zwischen den zweiten Öffnungen so angepaßt sind, daß die zu erwartende Fehljustierung kleiner ist als der Abstand der beiden äußeren Öffnungen minus die Länge der mittleren Öffnung. Durch eine solche geometrische Ausgestaltung der Öffnungen wird sichergestellt, daß in jedem Fall wenigstens eine funktionierende Zener-Diode hergestellt.

Im Folgenden wird die Erfindung anhand von Ausführungsbeispielen und den dazugehörigen Figuren näher erläutert.

Figur 1 zeigt beispielhaft ein erfindungsgemäße Zenerdiode in einer schematischen Draufsicht.

Figur 2 zeigt beispielhaft die Anordnung zweier Masken zur Herstellung einer Zenerdiode in einer schematischen Draufsicht.

Figur 3 zeigt beispielhaft die Fehljustierung zweier Masken zur Herstellung der Zenerdiode in einer schematischen Draufsicht.

Figur 4 zeigt beispielhaft die Fehljustierung zweier Masken bei der Herstellung einer Doppel-Zenerdiode in einer schematischen Draufsicht.

Die Figuren 5A und 5B zeigen beispielhaft Doppel-Zenerdioden in einer schematischen Draufsicht.

Figur 6 zeigt beispielhaft eine Zenerdioden-Schaltung in einem schematischen Schaltbild.

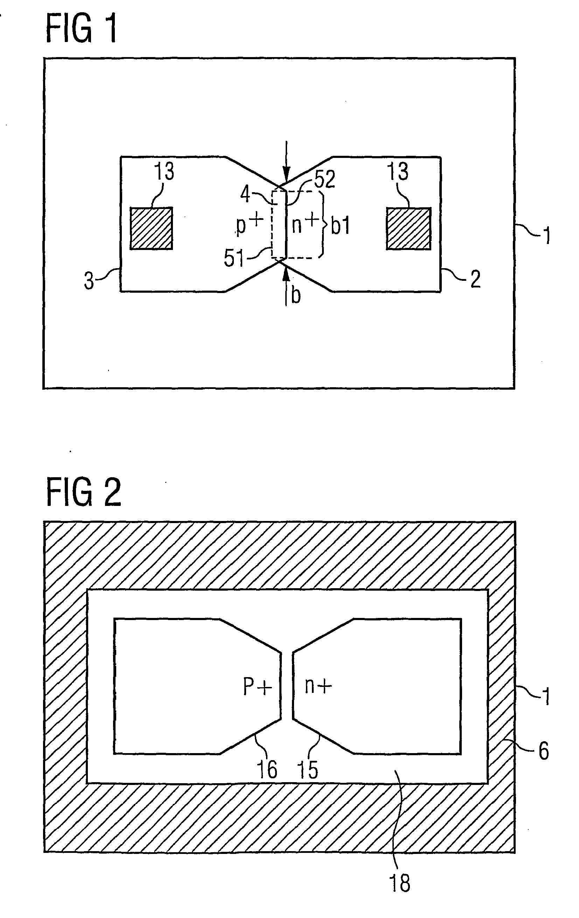

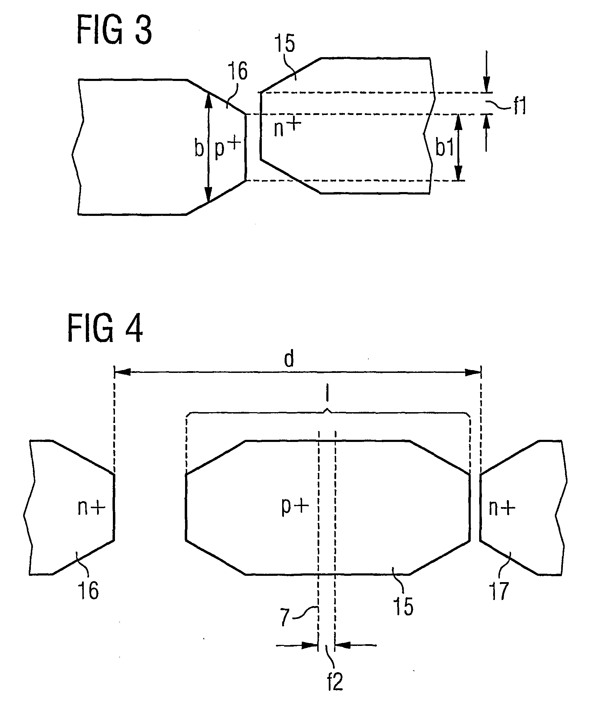

Figur 1 zeigt ein Halbleitersubstrat 1, das ein n-dotiertes Gebiet 2 und p-dotiertes Gebiet 3 aufweist. Die dotierten Gebiete 2, 3 sind jeweils mit einer Kontaktfläche 13 versehen, mit deren Hilfe sie elektrisch kontaktiert werden können. Das Halbleitersubstrat kann beispielsweise ein Silizium-Substrat sein. Die dotierten Gebiete 2, 3 können beispielsweise in einer n-Wanne oder auch in einer p-Wanne angeordnet sein. Das n-dotierte Gebiet weist eine n+-Dotierung auf. Das p-dotierte Gebiet weist eine p+-Dotierung auf. Die dotierten Gebiete 2, 3 überlappen einander nach Beendigung des Herstellungsverfahrens und bilden im Überlappungsbereich einen pn-Übergang 4. Die dotierten Gebiete 2, 3 weisen an den einander zugewandten Enden eine zum jeweils anderen dotierten Gebiet 2, 3 hin abnehmende Breite b auf. Die dotierten Gebiete 2, 3 laufen sozusagen spitz aufeinander zu. Jedoch weisen sie an den einander zugewandten Enden keine Spitzen auf, sondern sie sind an den einander zugewandten Enden durch gerade Kanten 51, 52 begrenzt. Die dotierten Gebiete 2, 3 weisen also abgeflachte Spitzen auf. Sie können vorteilhafterweise trapezförmig ausgestaltet sein. Die Mindestbreite b1 der dotierten Gebiete 2, 3 an den einander zugewandten Enden ist dabei so gewählt, daß sie an die maximal zu erwartende Fehljustierung angepaßt ist (vergleiche dazu auch Figur 3). Durch die sich verringernde Breite haben die dotierten Gebiete und die daraus gebildete Zenerdiode den Vorteil, daß ein zur Programmierung der Zenerdiode eingesetzter elektrischer Strom räumlich konzentriert werden kann, wodurch der zum Durchbrennen der Diode erforderliche Strom relativ klein gehalten werden kann. Durch das Abschneiden der Spitzen der dotierten Gebiete kann eine Kompensation von Fehljustierungen erfolgen.

Die in einem Layout festgelegte Zeichnung der Maskenöffnungen enthält meistens ein sogenanntes Bias, das ist eine bewußte Verkleinerung beziehungsweise Vergrößerung gegenüber der beabsichtigten endgültigen Größe der Öffnung. Sie soll den im Herstellungsverfahren bereits bekannten Verschiebungen der Öffnungsgrenzen (durch Fotolackbelichtung und -entwicklung, laterale Ausdiffusion) entgegenwirken. Es ist daher üblicherweise so, daß die Zeichnung der p- und n-Gebiete nicht den endgültigen Abstand der beiden Gebiete darstellt. Wohl aber müssen diese Effekte alle bereits in der Zeichnung berücksichtigt werden, um ein optimales Funktionieren des Elementes zu garantieren. Es gibt daher Fertigungsprozesse, wo sich die Zeichnung der p- und n-Gebiete bereits überlappt (wie zum Beispiel in Figur 1 dargestellt).

Die dotierten Gebiete weisen vorzugsweise Abmessungen von 1 bis 10 $\mu$m auf.

Figur 2 zeigt ein Halbleitersubstrat 1 mit einer Diffusionsmaske 6, die beispielsweise ein Feldoxid (SiO$_2$)sein kann. Die Diffusionsmaske 6 weist eine Öffnung 18 auf, in der zwei weitere Öffnungen 15, 16 angeordnet sind. Diese Öffnungen 15, 16 gehören zu Masken, mit deren Hilfe die Zenerdiode strukturiert wird. Dabei wird das Halbleitersubstrat 1 unterhalb der ersten Öffnung 15 n+ dotiert. Das Halbleitersubstrat 1 wird unterhalb der zweiten Öffnung 16 p+ dotiert. Es ist zu beachten, daß die Form der Öffnungen 15, 16 nicht notwendigerweise mit den Umrissen der dotierten Gebiete 2, 3 übereinstimmen, da es beispielsweise auf Grund von Strahldivergenz oder nach der Dotierung einsetzender Diffusionsvorgänge durchaus noch zu Änderungen in der Form der dotierten Gebiete 2, 3 kommen kann. Das für die dotierten Gebiete 2, 3 hinsichtlich der Form an den einander zugewandten Enden und hinsichtlich der Breite bzw. der Mindestbreite b1 Gesagte gilt auch für die Öffnungen 15, 16 von zwei verschiedenen Masken, die zur Herstellung der Zenerdiode verwendet werden.

Die Dotierung in den Öffnungen 15, 16 kann beispielsweise durch Ionenimplantation oder auch durch Diffusion erfolgen.

Figur 3 zeigt zwei Öffnungen 15, 16, wobei die Öffnung 15 zu einer ersten Maske und die Öffnung 16 zu einer zweiten Maske gehören. Die beiden Masken sollen zueinander justiert werden.

In Richtung der abnehmenden Breite b bzw. in Richtung der Mindestbreite b1 weist die zur Justierung der Masken verwendete Vorrichtung, beispielsweise eine Belichtungsmaschine, eine maximale Fehljustierung f1 auf. Durch entsprechende Wahl der Mindestbreiten b1 der Öffnungen 15, 16 kann eine solche maximale Fehljustierung f1 so ausgeglichen werden, daß auch bei maximaler Fehljustierung ein Überlappen der beiden durch die Öffnungen 15, 16 hergestellten dotierten Gebiete erfolgt und mithin eine Zenerdiode gebildet wird. Dazu ist es erforderlich, daß gilt:

$$b1 > f1.$$

Figur 4 zeigt die Herstellung einer Zenerdiode mittels einer ersten Maske, die eine Öffnung 15 aufweist. Eine zweite Maske weist Öffnungen 16, 17 auf der Oberfläche eines Siliziumsubstrats auf. Die Öffnungen 15 bzw. 16 und 17 sind spiegelsymmetrisch gestaltet zu einer vertikalen Ebene.

Gemäß Figur 4 gilt für die maximal zu erwartende Fehljustierung f2 in Richtung der Verbindung zwischen den Öffnungen 16, 17:

$$d-l \geq f2.$$

Dabei wurde in der Formel der Fall dargestellt, wo die Öffnungen 16, 17 in der Zeichnung einen Abstand haben.

Dabei ist 1 die Länge der Öffnung 15. Demnach wird der Abstand d zwischen den Öffnungen 16, 17 bzw. die Länge 1 der Öffnung 15 so gewählt, daß die Öffnung 15 bei der Justierung zu den Öffnungen 16, 17 nur zwischen den jeweils rechten (Öffnung 16) bzw. linken (Öffnung 17) Ende hin und her wandern kann. Die Position der Öffnung 15 ist dabei abhängig von der Justierung der Masken zueinander.

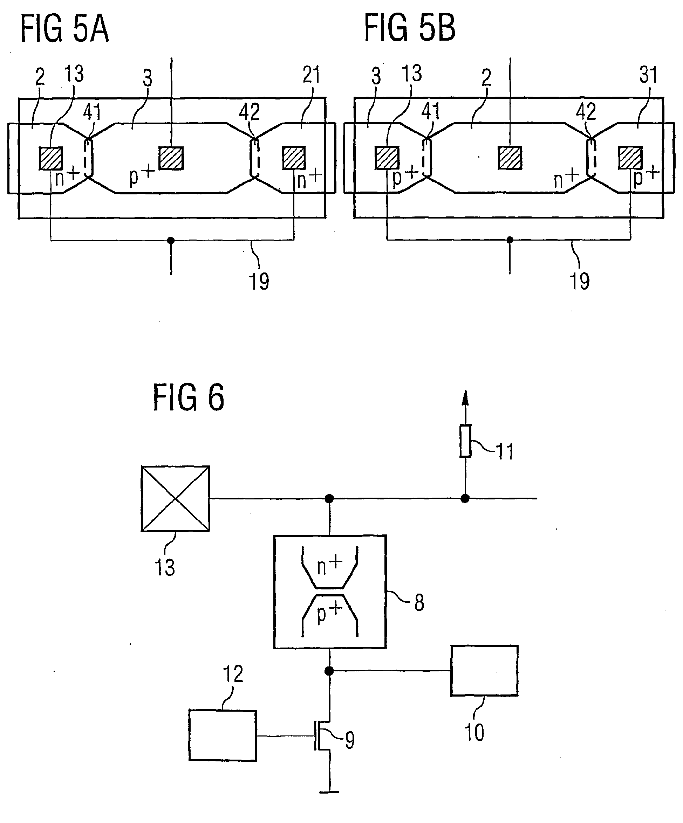

Die Figuren 5A und 5B zeigen jeweils eine Doppel-Zenerdiode mit jeweils drei dotierten Gebieten. Gemäß Figur 5A ist ein dotiertes Gebiet 2 sowie ein dotiertes Gebiet 21 n+ dotiert. Zwischen den dotierten Gebieten 2, 21 ist ein p+-dotiertes Gebiet 3 angeordnet. Die Formgebungen der dotierten Gebiete 2, 21, 3 sind gemäß Figur 1 bzw. gemäß Figur 3 gewählt. Jedes dotierte Gebiet 2, 3, 21 ist mit einer Kontaktfläche 21 versehen. Es sind ferner die Anschlußleitungen 19 an die Doppel-Zenerdiode angedeutet, wonach eine Parallelschaltung der linken Zenerdiode (gebildet durch den pn-Übergang 41) und der rechten Zenerdiode (gebildet durch den pn-Übergang 42) vorgesehen ist.

Gemäß Figur 5B sind im Unterschied zu Figur 5a lediglich die Dotierungen vertauscht. Das n+ dotierte Gebiet 2 ist zwischen den p+ dotierten Gebieten 3, 31 angeordnet.

Figur 6 zeigt eine Zenerdiodenschaltung mit einer Zenerdiode 8, die mit einer Vorrichtung zum Einprägen eines Stromes in die Zenerdiode 9, 12 verbunden ist. Dazu ist ein programmierender Transistor 9 mit der Zenerdiode 8 verbunden. An den programmierenden Transistor 9 ist eine Kontroll-Logik 12 angeschlossen. Die Kontroll-Logik 12 bestimmt, ob der Programmierende Transistor 9 durchschalten soll. Falls dies gegeben ist, fließt durch die Zenerdiode 8 ein hoher Strom, der die Zenerdiode 8 durchlegiert und die Zenerdiode in den programmierten Zustand überführt. Der Programmzustand der Zenerdiode 8 kann mittels eines Komparators 10 in Verbindung mit einem sogenannten "pull up-Widerstand" 11 ausgelesen werden. Es ist darüber hinaus noch eine Kontaktfläche 13 vorgesehen, an die weitere elektrische bzw. elektronische Bauelemente oder Komponenten an die Zenerdiode 8 angeschlossen werden können beziehungsweise die benötigte Programmierspannung zugeführt werden kann.

Eine typische Schaltspannung, mit der die Zenerdiode beaufschlagt wird, liegt zwischen 3 und 5 Volt.

Der zum Durchlegieren der Zenerdiode erforderliche Programmierstrom liegt typischerweise bei 100 mA, der Auslesestrom bei 50 $\mu$A. Die Programmierspannung, die benötigt wird, hängt von der Größe des Programmiertransistors ab, liegt aber typischerweise zwischen 5 und 8 Volt.

Die vorliegende Erfindung ist nicht auf einmalig programmierbare Bauelemente beschränkt, sondern läßt sich im allgemeinen auf jede Form von Zenerdiode anwenden.

**Patentansprüche**

1. Zenerdiode,

    - mit einem halbleitenden Substrat (1),
    - das ein n-dotiertes Gebiet (2) und ein p-dotiertes Gebiet (3) aufweist,
    - bei der die dotierten Gebiete (2, 3) einen lateralen pn-Übergang (4) bilden, **dadurch gekennzeichnet, daß**
    - die dotierten Gebiete einander zugewandte, abgeflachte Spitzen aufweisen.

2. Zenerdiode nach Anspruch 1,
    bei der die einander zugewandten Enden der dotierten Gebiete (2, 3) eine Mindestbreite (b1) aufweisen.

3. Zenerdiode nach einem der Ansprüche 1 bis 2,
    bei der die einander zugewandten Enden der dotierten Gebiete (2, 3) durch gerade Kanten (51, 52) begrenzt sind.

4. Zenerdiode nach einem der Ansprüche 1 bis 3,

    - mit einem weiteren p-dotierten Gebiet (31),
    - bei der das n-dotierte Gebiet (2) zwischen zwei p-dotierten Gebieten (3, 31) angeordnet ist
    - bei der das n-dotierte Gebiet (2) mit jedem der p-dotierten Gebiete (3, 31) einen lateralen pn-Übergang (41, 42) bildet.

5. Zenerdiode nach einem der Ansprüche 1 bis 3,

    - mit einem weiteren n-dotierten Gebiet (2, 21),
    - bei der das p-dotierte Gebiet (3) zwischen zwei n-dotierten Gebieten (2, 21) angeordnet ist
    - bei der das p-dotierte Gebiet (3) mit jedem der n-dotierten Gebiete (2, 21) einen lateralen pn-Übergang (41, 42) bildet.

6. Zenerdiode nach einem der Ansprüche 1 bis 5,
    bei der alle dotierten Gebiete (2, 21, 3, 31) innerhalb einer einzigen Öffnung (18) einer Diffusionsmaske (6) angeordnet sind.

7. Zenerdiode nach einem der Ansprüche 4 bis 6,
    bei der die n-dotierten Gebiete (2, 21) und die p-dotierten Gebiete (3, 31) jeweils symmetrisch zu einer senkrecht zur Substratoberfläche verlaufenden Ebene (7) ausgebildet sind.

8. Zenerdiode nach einem der Ansprüche 1 bis 7,
    bei der die n-dotierten Gebiete (2, 21) n+-dotiert sind und die p-dotierten Gebiete (3, 31) p+-dotiert sind.

9. Zenerdiode nach einem der Ansprüche 1 bis 8,
    bei der die n- und p-dotierten Gebiete (2, 3; 3, 21; 2, 31) einander überlappen.

10. Zenerdiode nach einem der Ansprüche 1 bis 9,

    - bei der die dotierten Gebiete (2, 21, 3, 31) durch photolithographische Masken hergestellt sind und
    - bei der die Mindestbreiten (b1) an die maximal zu erwartende Fehljustierung (f1) der Masken zueinander angepaßt sind.

11. Zenerdiode nach einem der Ansprüche 4 oder 5,
    bei der die dotierten Gebiete (2, 21, 3, 31) durch photolithographische Masken hergestellt sind und

    - bei der der Abstand (d) zwischen den Gebieten (2, 21, 3, 31) mit gleicher Dotierungspolarität an die zu erwartende Fehljustierung (f2) der Masken zueinander angepaßt sind.

12. Zenerdiodenschaltung,

    - mit einer Zenerdiode (8) nach einem der Ansprüche 1 bis 11,
    - bei der die Zenerdiode (8) mit einem Mittel (9, 12) zum Einprägen eines Stromes verbunden ist und
    - bei der die Zenerdiode (8) mit Mitteln (9, 10, 11, 12) zum Auslesen des Zustandes der Diode (8) verbunden ist.

13. Verfahren zur Herstellung einer Zenerdiode gemäß Anspruch 1,

    - wobei zwei Masken photolithographisch auf einem halbleitenden Substrat (1) erzeugt werden,
    - wobei jede Maske eine Öffnung (15, 16) auf der Substratoberfläche aufweist,
    - wobei die Öffnungen (15, 16) auf den aneinander zugewandten Seiten eine bis auf eine endliche Mindestbreite (b1) hin abnehmende Breite (b) aufweisen,
    - wobei die Mindestbreite (b1) an die maximal zu erwartende Fehljustierung der Masken zueinander angepaßt ist,
    - wobei das halbleitende Substrat (1) unterhalb der ersten Öffnung (15) n+ oder p+ und das halbleitende Substrat (1) unterhalb der zweiten Öffnung (16) mit einer von der ersten Öffnung (15) verschiedenen Dotierung n+- oder p+-dotiert ist, mit folgenden Schritten:

        a) Herstellen einer ersten Maske
        b) Justieren der zweiten Maske relativ zur ersten Maske
        c) Herstellen der zweiten Maske.

**14.** Verfahren zur Herstellung einer Zenerdiode gemäß Anspruch 1,

- wobei zwei Masken photolithographisch auf einem halbleitenden Substrat (1) erzeugt werden
- wobei die erste Maske eine erste Öffnung (15) und die zweite Maske zwei weitere Öffnungen (16, 17) auf der Substratoberfläche aufweisen,
- wobei die erste Öffnung (15) zwischen den beiden weiteren Öffnungen (16, 17) angeordnet ist,
- wobei die Öffnungen (15, 16, 17) auf den einander zugewandten Seiten eine bis auf eine endliche Mindestbreite (b1) hin abnehmende Breite (b) aufweisen,
- wobei die Mindestbreite (b1) an die maximal zu erwartende Fehljustierung (f1) der Masken zueinander angepaßt ist,
- wobei das halbleitende Substrat (1) unterhalb der ersten Öffnung (15) n+ oder p+ dotiert ist und wobei das halbleitende Substrat (1) unterhalb der weiteren Öffnungen (16, 17) mit einer von der ersten Öffnung (15) verschiedenen Dotierung n+ oder p+ dotiert werden, mit folgenden Schritten:

a) Herstellen der ersten Maske
b) Justieren der zweiten Maske relativ zur ersten Maske
c) Herstellen der zweiten Maske.

**15.** Verfahren nach Anspruch 14,
wobei der Abstand (d) der Öffnungen (16, 17) der zweiten Maske an die maximal zu erwartende Fehljustierung (f2) der Masken zueinander angepaßt ist.

**Claims**

**1.** A Zener diode,

- comprising a semiconducting substrate (1),
- which has a n-doped zone (2) and a p-doped zone (3),
- wherein the doped zones (2, 3) define a lateral pn junction (4), **characterized in that**
- the doped zones have flattened tips opposing each other.

**2.** The Zener diode according to claim 1,
wherein the opposing ends of the doped zones (2, 3) have a minimum width (b1).

**3.** The Zener diode according to any of the claims 1 to 2,
wherein the opposing ends of the doped zones (2, 3) are delimited by straight edges (51, 52).

**4.** The Zener diode according to any of the claims 1 to 3,

- comprising a further p-doped zone (31),
- wherein the n-doped zone (2) is arranged between two p-doped zones (3, 31),
- wherein the n-doped zone (2) defines a lateral pn junction (41, 42) with each of the p-doped zones (3, 31).

**5.** The Zener diode according to any of the claims 1 to 3,

- comprising a further n-doped zone (2, 21),
- wherein the p-doped zone (3) is arranged between two n-doped zones (2, 21),
- wherein the p-doped zone (3) defines a lateral pn junction (41, 42) with each of the n-doped zones (2, 21).

**6.** The Zener diode according to any of the claims 1 to 5, wherein all doped zones (2, 21, 3, 31) are arranged within a single opening (18) of a diffusion mask (6).

**7.** The Zener diode according to any of the claims 4 to 6, wherein the n-doped zones (2, 21) and the p-doped zones (3, 31) each are designed so as to be symmetrical to a plane (7) extending perpendicularly to the substrate surface.

**8.** The Zener diode according to any of the claims 1 to 7, wherein the n-doped zones (2, 21) have a n+-type doping and the p-doped zones (3, 31) have a p+-type doping.

**9.** The Zener diode according to any of the claims 1 to 8, wherein the n-doped and p-doped zones (2, 3; 3, 21; 2, 31) overlap each other.

**10.** The Zener diode according to any of the claims 1 to 9,

- wherein the doped zones (2, 21, 3, 31) are manufactured by means of photolithographic masks and
- wherein the minimum widths (b1) are matched with the maximum expectable misalignment (f1) of the masks relative to each other.

**11.** The Zener diode according to any of the claims 4 or 5, wherein the doped zones (2, 21, 3, 31) are manufactured by means of photolithographic masks and

- wherein the distance (d) between the zones (2, 21, 3, 31) with identical doping polarity are matched with the expectable misalignment (f2) of the masks relative to each other.

**12.** A Zener diode circuit,

- comprising a Zener diode (8) according to any of the claims 1 to 11,
- wherein the Zener diode (8) is connected with a device (9, 12) for impressing a current and
- wherein the Zener diode (8) is connected with devices (9, 10, 11, 12) for reading out the condition of the diode (8).

13. A method of manufacturing a Zener diode according to claim 1,

- two masks being produced on a semiconducting substrate (1) by means of photolithography,
- each mask having an opening (15, 16) on the substrate surface,
- the openings (15, 16), on the sides opposing each other, having a width (b) which decreases down to a finite minimum width (b1),
- the minimum width (b1) being matched with the maximum expectable misalignment of the masks relative to each other,
- the semiconducting substrate (1) underneath the first opening (15) having a n+ or p+-type doping and the semiconducting substrate (1) underneath the second opening (16) having a n+ or p+-type doping which is different from that of the first opening (15),
comprising the following steps:

a) manufacturing a first mask
b) adjusting the second mask relative to the first mask
c) manufacturing the second mask.

14. A method of manufacturing a Zener diode according to claim 1,

- two masks being produced on a semiconducting substrate (1) by means of photolithography,
- the first mask having a first opening (15) and the second mask having two further openings (16, 17) on the substrate surface,
- the first opening (15) being arranged between the two further openings (16, 17),
- the openings (15, 16, 17), on the sides opposing each other, having a width (b) which decreases down to a finite minimum width (b1),
- the minimum width (b1) being matched with the maximum expectable misalignment (f1) of the masks relative to each other,
- the semiconducting substrate (1) underneath the first opening (15) having a n+-type or p+-type doping and the semiconducting substrate (1) underneath the further openings (16, 17) being doped with a n+-type or p+-type doping which is different from that of the first opening (15),
comprising the following steps:

a) manufacturing the first mask
b) adjusting the second mask relative to the first mask
c) manufacturing the second mask.

15. The method according to claim 14,
the distance (d) of the openings (16, 17) of the second mask being matched with the maximum expectable misalignment (f2) of the masks relative to each other.

## Revendications

1. Diode Zener,

- comprenant un substrat semi-conducteur (1),
- présentant une zone dopée N (2) et une zone dopée P (3),
- où les zones dopées (2, 3) forment une jonction PN latérale (4), **caractérisée en ce que**
- les zones dopées présentent des pointes aplaties se faisant face l'une à l'autre.

2. Diode Zener selon la revendication 1,
où les extrémités se faisant face l'une à l'autre des zones dopées (2, 3) présentent une largeur minimale (b1).

3. Diode Zener selon l'une des revendications 1 à 2,
où les extrémités se faisant face l'une à l'autre des zones dopées (2, 3) sont limitées par des bords droits (51, 52).

4. Diode Zener selon l'une des revendications 1 à 3,

- comprenant une autre zone dopée P (31),
- où la zone dopée N (2) est disposée entre deux zones dopées P (3, 31),
- où la zone dopée N (2) forme une jonction latérale PN (41, 42) avec chacune des zones dopées P (3, 31).

5. Diode Zener selon l'une des revendications 1 à 3,

- comprenant une autre zone dopée N (2, 21),
- où la zone dopée P (3) est disposée entre deux zones dopées N (2, 21),
- où la zone dopée P (3) forme une jonction latérale PN (41, 42) avec chacune des zones dopées N (2, 21).

6. Diode Zener selon l'une des revendications 1 à 5,
où toutes les zones dopées (2, 21, 3, 31) sont disposées à l'intérieur d'une seule ouverture (18) d'un masque de diffusion (6).

7. Diode Zener selon l'une des revendications 4 à 6,
où les zones dopées N (2, 21) et les zones dopées P (3, 31) sont respectivement agencées symétriquement par rapport à un plan (7) perpendiculaire à la surface du substrat.

**8.** Diode Zener selon l'une des revendications 1 à 7, où les zones dopées N (2, 21) sont dopées N+ et les zones dopées P (3, 31) sont dopées P+.

**9.** Diode Zener selon l'une des revendications 1 à 8, où les zones dopées N et P (2, 3 ; 3, 21 ; 2, 31) se chevauchent l'une l'autre.

**10.** Diode Zener selon l'une des revendications 1 à 9,

   - où les zones dopées (2, 21, 3, 31) sont fabriquées au moyen de masques photolithographiques et
   - où les largeurs minimales (b1) sont adaptées à l'erreur d'alignement maximale prévisible (f1) des masques entre eux.

**11.** Diode Zener selon l'une des revendications 4 ou 5,

   - où les zones dopées (2, 21, 3, 31) sont fabriquées au moyen de masques photolithographiques et
   - où l'écartement (d) entre les zones (2, 21, 3, 31) de même polarité de dopage est adapté à l'erreur d'alignement maximale prévisible (f2) des masques entre eux.

**12.** Circuit de diode Zener,

   - comprenant une diode Zener (8) selon l'une des revendications 1 à 11,
   - où la diode Zener (8) est reliée à un moyen (9, 12) permettant d'appliquer un courant et
   - où la diode Zener (8) est reliée à des moyens (9, 10, 11, 12) permettant de relever l'état de la diode (8).

**13.** Procédé de fabrication d'une diode Zener selon la revendication 1,

   - deux masques étant produits par procédé photolithographique sur un substrat semi-conducteur (1),
   - chaque masque présentant une ouverture (15, 16) sur la surface du substrat,
   - les ouvertures (15, 16) présentant, sur les côtés se faisant face l'un à l'autre, une largeur (b) qui diminue jusqu'à une largeur minimale limitée (b1),
   - la largeur minimale (b1) étant adaptée à l'erreur d'alignement maximale prévisible (f1) des masques entre eux,
   - le substrat semi-conducteur (1) étant, sous la première ouverture (15), dopé N+ ou P+ et le substrat semi-conducteur (1) étant, sous la seconde ouverture (16), dopé avec un dopage N+ ou P+ différent de la première ouverture (15), comportant les étapes suivantes :

   a) fabrication d'un premier masque
   b) alignement du second masque relativement au premier masque
   c) fabrication du second masque.

**14.** Procédé de fabrication d'une diode Zener selon la revendication 1,

   - deux masques étant produits par procédé photolithographique sur un substrat semi-conducteur (1),
   - le premier masque présentant une première ouverture (15) et le second masque présentant deux autres ouvertures (16, 17) sur la surface du substrat,
   - la première ouverture (15) étant disposée entre les deux autres ouvertures (16, 17),
   - les ouvertures (15, 16, 17) présentant, sur les côtés se faisant face l'un à l'autre, une largeur (b) qui diminue jusqu'à une largeur minimale limitée (b1),
   - la largeur minimale (b1) étant adaptée à l'erreur d'alignement maximale prévisible (f1) des masques entre eux,
   - le substrat semi-conducteur (1) étant, sous la première ouverture (15), dopé N+ ou P+ et le substrat semi-conducteur (1) étant, sous les autres ouvertures (16, 17), dopé avec un dopage N+ ou P+ différent de la première ouverture (15),
   comportant les étapes suivantes :

   a) fabrication du premier masque
   b) alignement du second masque relativement au premier masque
   c) fabrication du second masque.

**15.** Procédé selon la revendication 14, où l'écartement (d) des ouvertures (16, 17) du second masque est adaptée à l'erreur d'alignement maximale prévisible (f2) des masques entre eux.

# FIG 1

# FIG 2

FIG 3

FIG 4

FIG 5A

FIG 5B

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5990534 A
- US 4672403 A
- EP 54740 A
- EP 883193 A